# EUROPEAN PATENT APPLICATION

(11) **EP 3 754 425 A1**
(43) Date of publication of application: **23.12.2020**
(21) Application number: 19181746.9
(22) Date of filing: 21.06.2019
(51) Int. Cl.: G03F 7/00, G03F 7/004, G03F 7/20, H01L 21/033

(54) **METHOD FOR NANO-FABRICATION USING EUV-INDUCED SURFACE REACTIONS**

(71) Applicant: PAUL SCHERRER INSTITUT, 5232 Villigen PSI (CH)
(72) Inventor: EKINCI, Yasin, CH-8046 Zürich (CH); TSENG, Li-Ting, CH-5210 Windisch (CH)
(74) Representative: Fischer, Michael

(57) **Abstract**

It is the objective of the present invention to provide a method for large-area resistless patterning on hydrogen-terminated Si using EUV lithography that yields a high throughput of large-area patterning.

This objective is achieved according to the present invention by a method for large-area resistless patterning on surficial-treated Si substrates using EUV lithography, comprising the steps of:
a) providing an Si substrate and treating the surface of the Si substrate at least partially in order to achieve an artificial layer or surface structure that is sensitive to EUV irradiation;
b) exposing the at least partially treated artificial layer or surface layer selectively to an EUV irradiation through a mask; and
c) treating the treated and irradiated Si surface in order to reveal the pattern provided by the mask and formed in the irradiated sections of the exposed regions of the at least partially treated Si surface.

As a result, EUV-radiation can be used for high resolution resistless patterning of substrates following a process where the surface of the Si substrate/wafer is at least partially hydrogen-passivated.

## Description

The present invention relates to a method for nano-fabrication based on the resistless transfer of large nanoscale patterns onto Si surface that can be achieved by surface reactions.

Current methods known to induce surface modification on Si are scanning tunneling microscopy (STM), scanning probe microscopy (SPM) and electron beam lithography (EBL). However, these are all direct write techniques with a major drawback of low throughput. Photolithography, on the other hand, as a parallel method is capable of large-area patterning with high throughput, yet the UV wavelength limits the resolution. Nonetheless, the present photolithography technique is the most favorized technique and is usually performed by transferring designed patterns through a photoresist spin-coated on the Si surface. As the feature size shrinks, a thinner photoresist is required to avoid pattern collapse. Therefore, an underlayer is often needed for further device processing. There are still challenges in photoresist material development. Firstly, the photoresists should have small molecules to realize high resolution and low line edge roughness of the patterns. Secondly, the photoresist properties should be compatible with underlayer materials. Therefore, the elimination of using photoresist excludes the additional material issues..
On the other hand, EUV lithography is becoming the leading lithography technique in semiconductor manufacturing, due to its short wavelength and the ability to achieve ultrahigh-resolution patterning for current and upcoming technology nodes.

It is therefore the objective of the present invention to provide a method for nano-fabrication based on the (photo)-resistless transfer of large nanoscale patterns onto Si surface that can be achieved by appropriate surface reactions.

This objective is achieved according to the present invention by a method for large-area (photo-)resistless patterning on surficial-treated Si substrates using EUV lithography, comprising the steps of:
a) providing an Si substrate and treating the surface of the Si substrate at least partially in order to achieve an artificial layer or surface structure that is sensitive to EUV irradiation;
b) exposing the at least partially treated artificial layer or surface layer selectively to an EUV irradiation through a mask; and
c) treating the treated and irradiated Si surface in order to reveal the pattern provided by the mask and formed in the irradiated sections of the exposed regions of the at least partially treated Si surface.

Therefore, the present invention has the advantages to simplify the process without the use of photoresists and improve the resolution that normally limited by the photoresists. The operation of the present invention is photo-resistless lithography, that is using EUV photons to direct surface modification, i.e. bond scission, surface oxidation, etching, growth, for further processing leading to patterning of the Si surface. In general, the present invention therefore only requires three major steps:
(1) Si surface treatment and functionalization;
(2) EUV exposure on functionalized Si surface; and
(3) Post-exposure treatment.

In a preferred embodiment of the present invention, the surface of the Si substrate is treated at least partially with fluoric acid leaving behind an at least partially hydrogen-passivated Si surface. Subsequently, the at least partially hydrogen-passivated Si surface is further treated with a basic solution, preferably tetramethylammonium hydroxide (TMAH) solution.

Another preferred embodiment of the present invention can be achieved, when the at least partially hydrogen-passivated Si surface is transferred into H-terminated and oxidized surface wherein the EUV irradiation is used to desorb hydrogen on the hydrogen-terminated Si surface and creates bare Si surface on the exposed regions;
the exposed regions get oxidized accordingly, leading to two different Si surface structures, H-terminated silicon and silicon dioxide;
said two different Si surface structures being treated with atomic layer deposition (ALD) to achieve the selective growth of thin films based on the adsorption of ALD precursors on the two different Si surface structures thereby exploiting the two different surface properties, silicon dioxide as being hydrophobic and H-terminated silicon as being hydrophilic.

Furthermore, a preferred embodiment can be achieved when the Si surface is treated to be passivated by a monolayer such as a functional monolayer of surface molecules comprising boron or phosphorus, preferably allylboronic acid pinacol ester or diethyl 1-propylphosphonate; said monolayer being prepared by a hydrosilylation method leading to the B- or P-containing monolayers being boned to the Si surface with Si-C bonds.

Accordingly, the EUV irradiation can be used to pattern a SiO₂ capping layer on top of the monolayer while the monolayer at uncapped areas is detached during rapid thermal annealing for doping to create locally doped Si. Another preferred embodiment can be achieved when the EUV irradiation is used to break the Si-C bond on the monolayer passivated Si surface; while the so-treated Si surface is then capped with a SiO₂ layer followed by rapid thermal annealing to induce a diffusion of B and P atoms to create a locally doped Si surface of the unexposed areas.

In order to achieve a direct etching or growth of a layer representing the desired pattern, it is also possible that a reaction induced by the EUV irradiation leads to a direct etching or growth of a layer without further steps, wherein prior to the EUV irradiation a carbon thin film or a carboneous thin film or an organic thin film is deposited on the Si surface or on the Si surface bearing an oxide layer depending on the application; the EUV exposure on the treated Si surface is then carried out in a vacuum chamber under a hydrogen ambient or oxygen environment;
said EUV irradiation induces a bond-dissociation of the injected gas and leads to atomic hydrogen or oxygen that reacts with carbon in the thin film and etches the thin film away on the Si surface; wherein the remaining thin film in the unexposed areas is then used as a hard mark to transfer the desired pattern into the Si surface.

Preferred embodiments of the present invention are described hereinafter in more detail with reference to the attached drawings which depict in:
- Figure 1: schematically a first EUV photoresist-less patterning lithography procedure;
- Figure 2: plots of normalized Si thickness as a function of EUV exposure dose in the procedure shown in Figure 1;
- Figure 3: a plane-view SEM image (a) and an AFM image (b) with a cross-sectional profile showing the 75 nm Si line gratings;
- Figure 4: schematically a second EUV photoresist-less patterning lithography procedure using atomic layer deposition;
- Figure 5: schematically a third EUV photoresist-less patterning lithography procedure using rapid thermal annealing; and
- Figure 6: schematically a forth EUV photoresist-less patterning lithography procedure using direct etching or growth by hydrogen ambient or oxygen environment.

The present invention has the advantages to simplify the process without the use of photoresists and improve the resolution that normally limited by the photoresists. The operation of the present invention is resistless lithography, that is using EUV photons (irradiation) to induce a direct surface modification, i.e. bond scission, surface oxidation, etching, growth, for further processing leading eventually to the patterning of the initial Si surface. The process avoids the conventional steps of the use of spin-coating a photoresist on the Si surface and exposure and development steps. The process comprises three major steps:
(1) Si surface treatment and functionalization for further processing;
(2) EUV exposure on the treated and functionalized Si surface; and
(3) Post-exposure treatment of the irradiated sections of the modified Si surface.

One of the examples according to the present invention to achieve resistless patterning is represented by a method for large-area resistless patterning on hydrogen-terminated Si substrates using EUV lithography, comprising the steps of:
a) providing an Si substrate and treating the surface of the Si substrate at least partially with fluoric acid leaving behind an at least partially hydrogen-passivated Si surface;
b) exposing the at least partially hydrogen-passivated Si surface selectively to an EUV irradiation through a lithographic mask; and
c) treating the irradiated Si surface with a tetramethylammonium hydroxide (TMAH) solution to reveal the pattern provided by the mask and formed in the irradiated sections of the exposed regions of the at least partially hydrogen-passivated Si surface.

As a result, synchrotron EUV-radiation can be used for high resolution resistless patterning of substrates following a process where the surface of the Si substrate/wafer is at least partially hydrogen-passivated.

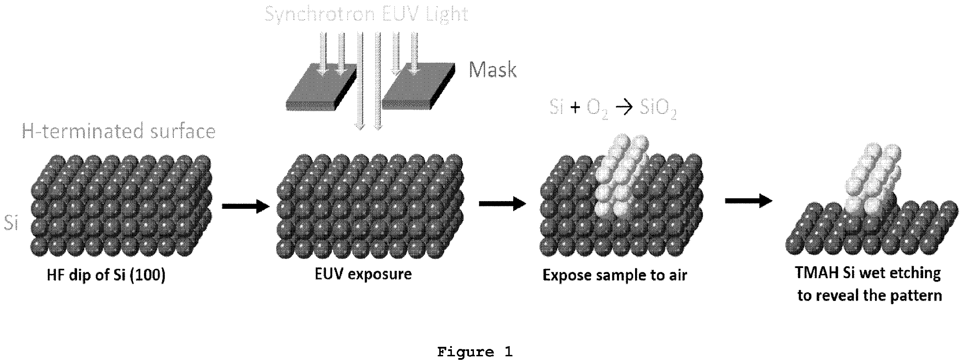

Figure 1 shows schematically a diagram of this EUV resistless lithography procedure. A p-type (100) Si wafer is dipped into an HF solution to remove its native oxide layer leaving behind a hydrogen-passivated Si surface. The surface is selectively exposed to an EUV irradiation through a structured (patterned) mask. After the exposure, the irradiated Si wafer is removed from the vacuum chamber and treated with a tetramethylammonium hydroxide (TMAH) solution to reveal the pattern formed in the exposed regions on the Si wafer.

The incident EUV irradiation induces a reaction at the surface of the Si wafer that involves the removal of surface hydrogen and the formation of an oxide layer in the exposed areas. H-terminated Si was firstly exposed with a selected range of doses via a 0.5×0.5 mm² open frame mask with a photon energy of 102 eV (λ=12.15 nm) followed by 25 wt% TMAH wet etching at 90 °C.

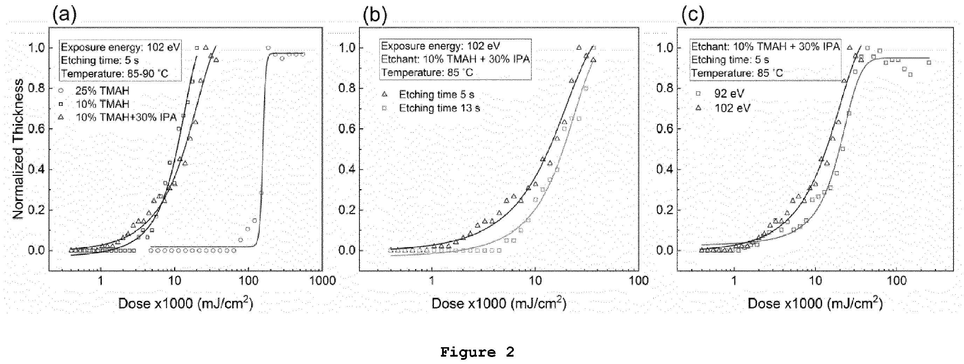

Figure 2 shows a number of plots of normalized Si thickness as a function of EUV exposure dose: Figure 2(a) EUV exposures at E=102 eV following different post-exposure treatments of Si wet etching with 25 wt% TMAH, 10 wt% TMAH and 10 wt% TMAH + 30 vol% IPA for 5 seconds; Figure 2(b) EUV exposures at E=102 eV following by 10 wt% TMAH + 30 vol% IPA post-exposure treatment for 5 seconds and 13 seconds and Figure 2(c) EUV exposures at E=102 eV and 92 eV following by 10 wt% TMAH + 30 vol% IPA for 5 seconds.

A negative-resist-like behavior is observed as the Si etching thickness saturates at a certain dose as shown in Fig. 2a (black line). The normalized Si thickness as a function of EUV exposure dose is fitted with a dose-response curve. In order to lower the exposure dose, the TMAH concentration was reduced to 10 wt% and also added 30 vol% of isopropyl alcohol (IPA). This enhances the anisotropic etching behavior along the [100] direction and also increases the etching selectivity between Si and SiO₂. As shown in the grey line in Fig. 2a, the exposure dose was reduced by a factor of 10 when IPA was added to 10 wt% TMAH.

The effect of etching time is shown in Fig. 2b. An increase of the etching time leads to thinner measured Si depth, suggesting that the exposed areas were also etched away, and hence to an increase of the doses. This result further confirms that the exposure dose is strongly related to the etching rate and selectivity. Moreover, another exposure was performed at E=92 eV (λ=13.5 nm), which is below the absorption edge of Si and therefore the surface of the bulk silicon is relatively transparent. Figure 2c shows that the lower incident photon energy does not significantly increase the dose with 10 wt% TMAH + 30 vol% IPA post-exposure treatment.

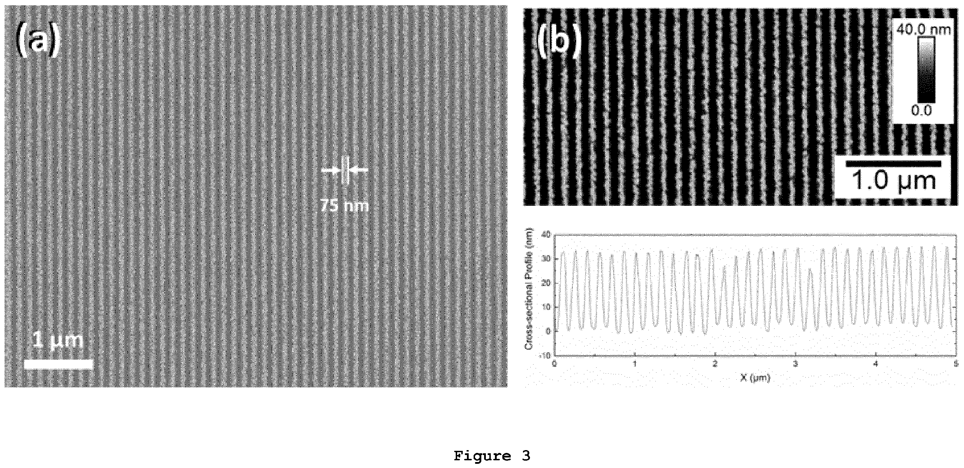

After this optimization of the EUV doses, photoresist-less patterning via EUV ATL patterning has been demonstrated. Figure 3(a) shows a plane-view SEM image and Figure 3(b) an AFM image with a cross-sectional profile showing the 75 nm Si line gratings fabricated by EUV resistless patterning after post-exposure treatment of Si wet etching with 10 wt% TMAH + 30 vol% IPA for 5 seconds. In detail, Figure 3a shows an SEM image of Si gratings with HP 75 nm obtained from the exposure with the optimized dose after etching by 10 wt% TMAH + 30 vol% IPA at 85 °C for 5 seconds. The cross-sectional profile obtained by atomic force microscopy (AFM) indicates that the height of the etched Si lines is 30 nm (Fig. 3b).

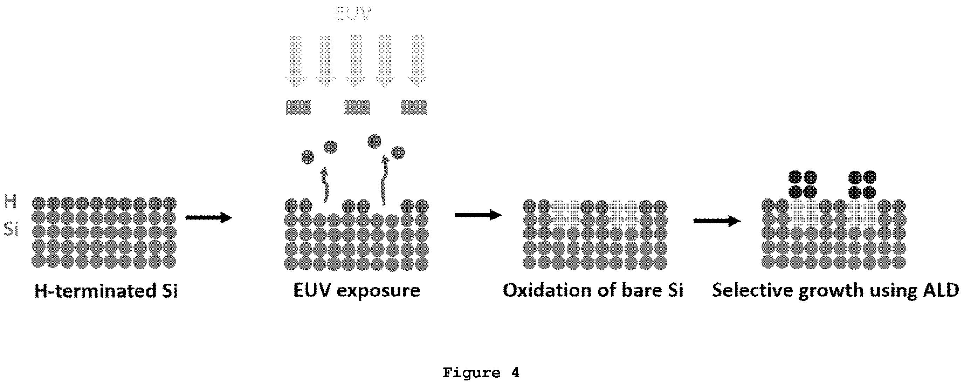

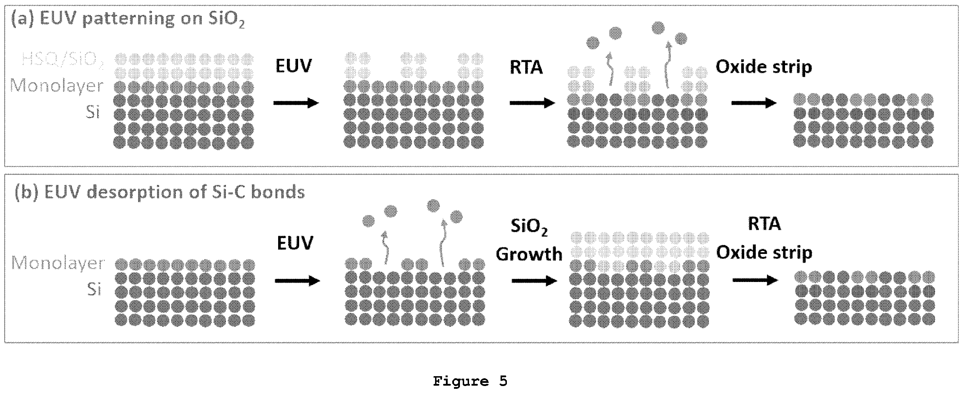

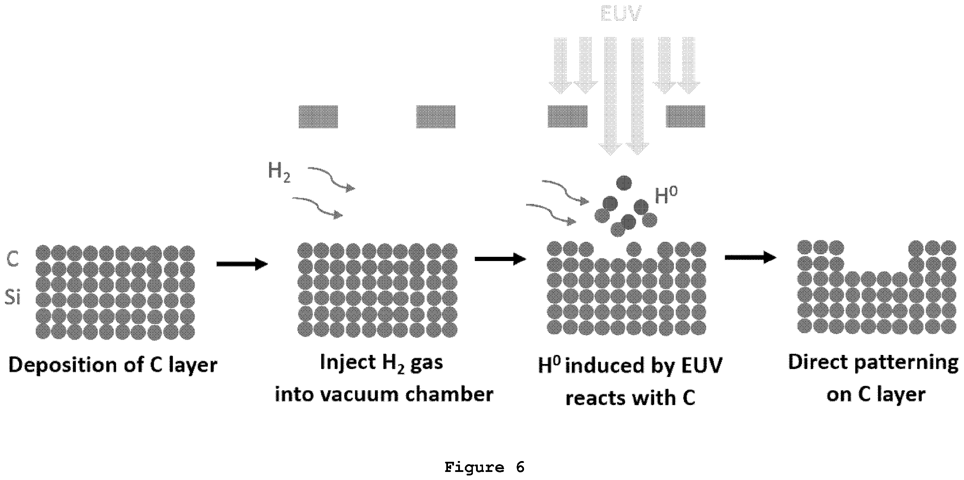

Alternative approaches of "photoresist-less patterning" on Si substrates or other semiconductor related thin films on Si substrates can be achieved by modifying the surface treatment and functionalization. The following methods are also viable examples under the general concept of the three-step procedure according to preferred embodiments of the present invention:
1.) The method is not limited to H-termination and wet etching. Alternatively, the H-terminated and oxidized surface can be used to provide the pattern in alternative ways. EUV irradiation (photons) are used to desorb hydrogen on hydrogen-terminated Si and created bare Si surface on the exposed regions. The exposed areas get oxidized, leading to two different Si surface characteristics, one represented by H-terminated silicon and the other represented by silicon dioxide. The sample is then treated with atomic layer deposition (ALD) to achieve the selective growth of thin films based on the adsorption of ALD precursors on the Si surface having the two different properties, silicon dioxide as hydrophobic and H-terminated silicon as hydrophilic, as this method is schematically shown in Fig. 4.
2.) The Si surface can be passivated by a monolayer, for example a functional monolayer of surface molecules comprising boron or phosphorus, such as allylboronic acid pinacol ester or diethyl 1-propylphosphonate. Said monolayer can be prepared by a hydrosilylation method. The B- or P-containing monolayers are boned to the Si surface with Si-C bonds. There are two ways to achieve localized doping when using this method. One way is to utilize EUV irradiation to pattern an SiO₂ capping layer on top of the monolayer. The monolayer at uncapped areas is detached during rapid thermal annealing (RTA) for doping to create locally doped Si, see Fig. 5a. Another way is using the EUV photons to break the Si-C bond on the functionalized Si surface. The Si surface are then capped with a SiO₂ layer following by RTA to induce a diffusion of B and P atoms to create a locally doped Si surface of the unexposed areas, as shown in Fig. 5b.
3.) Alternatively, the EUV irradiation induced reaction can lead to a direct etching or growth of a layer without further steps. A carbon thin film or a carboneous thin film or an organic thin film can be deposited on a clean surface, e.g. Si surface or a Si surface covered with an oxide layer; depending on the desired application. The EUV exposure on the carbon-comprising surface is then carried out in a vacuum chamber under a hydrogen ambient or oxygen environment. The EUV photons induce bond-dissociation of the injected gas and lead to atomic hydrogen or oxygen that can react with carbon and etch the carbon layer away on the Si surface, see Fig. 6. The carbon layer remaining in the unexposed areas is then used as a hard mark to transfer the pattern into Si. By directly modifying the bonding on Si surface using EUV photons, it prevents the pattern collapse and the resolution limit occurring in the photoresists and allows the possibility of high-resolution patterning for Si semiconductor device fabrication.

## Claims

1. A method for large-area resistless patterning on surficial-treated Si substrates using EUV lithography, comprising the steps of:
a) providing an Si substrate and treating the surface of the Si substrate at least partially in order to achieve an artificial layer or surface structure that is sensitive to EUV irradiation;
b) exposing the at least partially treated artificial layer or surface layer selectively to an EUV irradiation through a mask; and
c) treating the treated and irradiated Si surface in order to reveal the pattern provided by the mask and formed in the irradiated sections of the exposed regions of the at least partially treated Si surface.

2. The method according to claim 1 wherein the surface of the Si substrate is treated at least partially with fluoric acid leaving behind an at least partially hydrogen-passivated Si surface.

3. The method according to claim 2 wherein the treated and irradiated Si surface is further treated with a basic solution, preferably tetramethylammonium hydroxide (TMAH) solution.

4. The method according to claim 2 wherein the at least partially hydrogen-passivated Si surface is transferred into H-terminated and oxidized surface wherein the EUV irradiation is used to desorb hydrogen on the hydrogen-terminated Si surface and creates bare Si surface on the exposed regions;
the exposed regions get oxidized accordingly, leading to two different Si surface structures, H-terminated silicon and silicon dioxide;
said two different Si surface structures being treated with atomic layer deposition (ALD) to achieve the selective growth of thin films based on the adsorption of ALD precursors on the two different Si surface structures thereby exploiting the two different surface properties, silicon dioxide as being hydrophobic and H-terminated silicon as being hydrophilic.

5. The method according to claim 1, wherein Si surface is treated to be passivated by a monolayer such as a functional monolayer of surface molecules containing boron or phosphorus, preferably allylboronic acid pinacol ester or diethyl 1-propylphosphonate; said monolayer being prepared by a hydrosilylation method leading to the B- or P-containing monolayers being boned to the Si surface with Si-C bonds.

6. The method according to claim 5, wherein the EUV irradiation is used to pattern a SiO₂ capping layer on top of the monolayer while the monolayer at uncapped areas is detached during rapid thermal annealing for doping to create locally doped Si.

7. The method according to claim 5, wherein the EUV irradiation is used to break the Si-C bond on the monolayer passivated Si surface; while the so-treated Si surface is then capped with a SiO₂ layer followed by rapid thermal annealing to induce a diffusion of B and P atoms to create a locally doped Si surface of the unexposed areas.

8. The method according to claim 1 wherein a reaction induced by the EUV irradiation leads to a direct etching or growth of a layer without further steps, wherein prior to the EUV irradiation a carbon thin film or a carboneous thin film or an organic thin film is deposited on the Si surface or the Si surface with an oxide layer depending on the application; the EUV exposure on the treated Si surface is then carried out in a vacuum chamber under a hydrogen ambient or oxygen environment; said EUV irradiation induces a bond-dissociation of the injected gas and leads to atomic hydrogen or oxygen that reacts with carbon in the thin film and etches the thin film away on the Si surface; wherein the remaining thin film in the unexposed areas is then used as a hard mark to transfer the desired pattern into the Si surface.
